Europäisches Patentamt

European Patent Office

Office européen des brevets

(19)

(11) Publication number: **0 005 289**
**A1**

(12) # EUROPEAN PATENT APPLICATION

(21) Application number: 79200185.1

(22) Date of filing: **12.04.79**

(51) Int. Cl.²: **H 01 J 37/28, G 01 R 13/34**

(30) Priority: **17.04.78 US 897051**
**17.04.78 US 897052**

(43) Date of publication of application: **14.11.79**
**Bulletin 79/23**

(84) Designated Contracting States: **CH DE FR GB IT NL SE**

(71) Applicant: **North American Philips Corporation, 100 East 42nd Street 9th Floor, New York N.Y. 10017 (US)**

(72) Inventor: **Russ, John Christian, c/o INT. OCTROOIBUREAU BV Prof. Holstlaan 6, NL-5656 AA Eindhoven (NL)**
Inventor: **Carey, Robert, c/o INT. OCTROOIBUREAU BV Prof. Holstlaan 6, NL-5656 AA Eindhoven (NL)**
Inventor: **Chopra, Vinod Kumar, c/o INT. OCTROOIBUREAU BV Prof. Holstlaan 6, NL-5656 AA Eindhoven (NL)**
Inventor: **Rich, William Charles, c/o INT. OCTROOIBUREAU BV Prof. Holstlaan 6, NL-5656 AA Eindhoven (NL)**
Inventor: **Cwik, Christian Frederick, c/o INT. OCTROOIBUREAU BV Prof. Holstlaan 6, NL-5656 AA Eindhoven (NL)**

(74) Representative: **Scheele, Edial François et al, INTERNATIONAAL OCTROOIBUREAU B.V. Prof. Holstlaan 6, NL-5656 AA Eindhoven (NL)**

(54) **Multi-channel analyzer.**

(57) In a multi-channel x-ray fluorescence analyzer a multi-channel memory (64) is interconnected between an attribute memory bank (60, 62), a display circuitry (66) and an analog-digital converter (56). A memory channel is identi-field as a member of a small group of channels representing elemental energy peak width, wherein one or more of the channels of the group are located in the multi-channel memory of a computer (i.e., a first multi-channel memory) and others of the channels of the group are located in one or more further multi-channel memories that are, as stated above, not located in an associated computer but, instead, in a separate attribute memory bank, with the operation of the memory or memories of the attribute memory bank being configurated by an associated computer circuit and operating independently and asynchronously of the computer. The invention also covers a display circuitry (66) for a non-line television display (67).

16-3-1979                    1               PHA 20 798 ᶜ

"Multi-channel analyzer"


The present invention relates to a multi-channel analyzer, particularly to a multi-channel x-ray fluorescence analyzer.

Such kind of analysing apparatus are described in The Edase editor vol. 8 no.2, page 6-10. In an apparatus as described a sample of material is struck by an x-ray beam in known fashion and the radiation from the sample resulting from x-ray excitation thereof, is collected and analyzed. In another application a scanning electron microscope (SEM) is utilized, in which an electron beam strikes a sample and the resulting radiation from the sample is collected and anlyzed. According to the prior art, such analysis of the resulting radiation from the sample, involves feeding the signals or information from the sample into a pre-amplifier of a known multi-channel analyzer. The signals from the pre-amplifier are then fed into an analog-to-digital converter from which information is transferred to a comparator, which generally comprises an upper range limit comparator and a lower range limit comparator. These comparators serve to analyze the information received from the converter and to determine and respond to those items of information or signals whose intensity levels, which are indicative of elements present in the materials of the

0005289

sample, falls between the pre-established upper and lower range limits for which the comparators are set. The signals from the analog-to-digital converter are also fed into a multi-channel memory, where the various signals identifying the elemental characteristics of the analyzed sample, are stored.

The output signals from the comparators thus those signals which fall within the pre-established range defined by the comparators are fed into an event detector which can be an "OR-gate" and pulse former and which registers the occurrence of the various signals from the comparators. Signals or intelligence from the event detector are fed into the output circuitry which in turn can be fed to for example, a scanning electron microscope that constructs an image of the analyzed sample area in accordance with the incoming signals from the event detector.

The apparatus also includes a marker counter, whose function it is to produce indices on the display and locate them appropriately. The attributes can be, for example, the image intensity, or brightness, the display grid, the display range scale, the width of the display window, and, in spectrometry, the K.L. and M marks, as explained below.

Information from the multi-channel memory is fed into display circuitry of the apparatus, which can be the circuitry for a television display, on which there can be shown various information indicating the characteristics of the sample, one such characteristic being the intensity, or population, level of signals corresponding to a certain energy or wavelength indicative of a particular chemical element, e.g. iron, the intensity being related to the chemical content of this particular element in the sample. In this particular type of application, wavelength/energy information is stored in a number of sequential memory channels of the multi-channel memory.

In asmuch as particular energies, and, therefore, particular channels, relate to specific elements under analysis, it is often desirable to identify these specific energy channels, this being done by the prior art, as described above, by using a comparator or counter-type circuit.

The present invention seeks to provide an improved multi-channel analyzer system and is characterized in that it contains

a) an analog-to-digital converter 56 for receiving incoming signals,

b) a multi-channel memory 64 connected to the converter,

c) an attribute memory bank 58 comprising at least one attribute memory and being connected to the multi-channel memory,

d) a display circuitry 66 connected to the attribute memory bank and to said multi-channel memory,

e) a display device connected to the display circuitry,

f) an output circuitry 68 connected to the output memory band, and

g) an output device 69 for receiving and demonstrating the signals from the output circuitry.

According to the invention, the specific energy channels are depositories for signals or information from the apparatus that operates on the specimen by radiation and detection, such signals indicating various characteristics of the specimen, e.g., the relative concentrations of the elements present in the materials of the specimen.

While, as previously stated, the above prior art apparatus employs comparator-or counter-type circuits for identifying specific energy channels, the present invention involves the software-controlled assignment of attributes to discrete hardware memory channels, to allow a synchronous real-time hardware response. The principle of attribute memory involves pre-assigning markers, which signify specific characteristics, or attributes, onto an attribute memory bank that is not in an associated computer, but, instead, is provided by dedicated hardware memory of the multi-channel analyzer. The contents of the attribute memory bank are configured by an associated computer circuit but the attribute memory bank operates independently and asynchronously of the computer.

'A multi-channel memory having, e.g., 1000 channels with 4 assignable attributes would provide a 1000 word by 4 bit attribute memory bank.

In the present invention, a memory channel is identified as a member of a small group of channels representing a specific elemental energy peak width, wherein one or more of the channels of the group are located in the multi-channel memory of the computer (i.e., a first multi-channel memory) and others of the channels of the group are located in one or more further multi-channel memories that are, as stated above, located not in an associated computer, but, instead, are in a separate attribute memory bank, with the operation of the memory or memories of the attribute memory bank being configured by the associated computer circuit and operating independently and asynchronously of the computer. The difficulty to detect associated multiple peaks in the non-configuous channels are over-comed with the apparatus according to the present invention.

An advantage of the present invention is that its employment of a multi-channel analyzer attribute memory provides unlimited flexibility in detecting associated multiple peaks in the non-contiguous channels. The present invention is also usable as a single channel analyzer. In a preferred embodiment of the invention the display circuitry of the analyzer apparatus comprises

a) means for producing a maximum signal value ($N_{max}$) to be fit to a signal truncator 74,

b) a frequency ratioer 70 connected to the truncator and to a system frequency clock 7,

c) a first gate 86 connected to the frequency ratioer for receiving a display synchronizing signal F,

d) a counter 88 connected to the first gate, said counter receiving signals ($N_{channel}$) to be monitored,

e) a zero detector 90 connected to the counter, and

f) a second gate 92 connected to the zero detector and to the first gate for receiving a television
synchronizing signal TF from the first gate the second gate
providing an output signal z modulating the display device.
Brief description of the drawings.

        Fig. 1 is a schematic block diagram of a circuit in the prior art for processing spectral data, using
a comparator-type circuit as described.

        Fig. 2 is a schematic block diagram of an
apparatus according to the present invention, employing a
multi-channel memory and an attribute memory bank providing
non-contiguous memory channels.

        Figure 3 is a schematic representation of digital means of the display circuitry according to a preferred
embodiment of the present invention.

        Figure 4 is a schematic depiction of a vertical
television raster representing scan timing data.

        Figure 5 is a schematic representation of analog
means for achieving a vertical television raster output
spectrum.

        Figure 6 is a schematic representation of
digital means for achieving horizontal television raster
output spectrum.

        Figure 7 is a schematic representation of
analog means according to another embodiment of the present
invention, for achieving horizontal television raster.

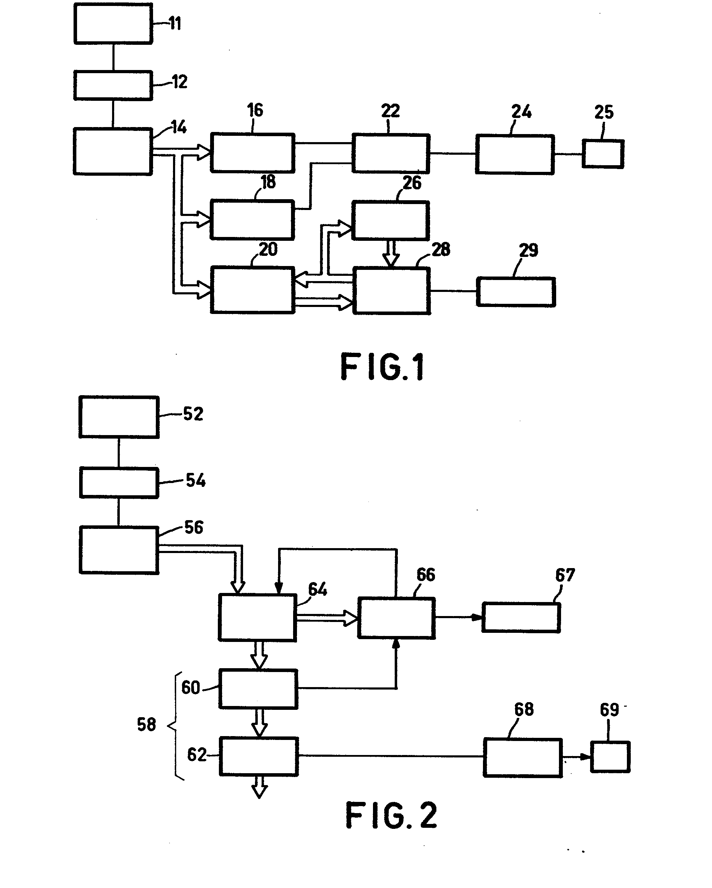

        In fig. 1 an x-ray detector 11, a pre-amplifier
12, an analog-digital converter 14, an upper limit comparator 16, a lower limit comparator 18, a multi-channel memory
20, an event detector 22, an output circuitry 24, a scanning electron microscope 25, a marker counter 26 a display
circuitry 28 and a display 29 are listed and interconnected
as described above in accordance with prior art.

        The preferred embodiment of fig. 2 is related
to an x-ray spectameter but can be used in other types of
analysator apparatus as well. Signals generated by an x-ray
detector 52 in response to radiation emanating from an
x-ray impinged sample, not shown but previously described,
the signal population and makeup thus, the energy of the signal which is dictated by the energy and wavelength of the emanated radiation, indicate various characteristics of the sample, e.g. the identities of the elements present in the sample material and their relative concentrations. These signals are transferred, preferably, to a pre-amplifier 54, whose output is then fed into an analog-to-digital converter 56.

The digital data from the a.d. converter 56 are fed into a multi-channel memory 64 and further into an attribute memory bank 58, which can comprise one or more attribute memory components 60, 62, etc. The output of the multi-channel analyzer is fed into a display circuitry 66, to which a television display 67 maintained to equal or exceed somewhat the value of the highest peak of the information being collected. The means comprises apparatus to achieve a display of line G on the television display screen the contents of a particular channel, N, are placed in a count-down counter whose content is monitored. At time $t_2$ the counter is counted down by a clock F and simultaneously the Z mode of the tube is brightened. When the contents of the counter are zero (at $t_3$) the brightness modulation is switched off. To ensure the correct operation, the following parameters are employed:

$$f = \frac{Nmax}{T\ histogram}$$

$$T\ bright = \frac{Nchannel}{N\ max} \times T\ histogram$$

$$= \frac{N\ channel}{f}$$

$$T\ histogram = T\ scan \times k$$

Where f is the clock frequency,

N max is the vertical scale maximum value,

T historgram is the time to display a line of maximum amplitude,

T scan is the sweep or scan time of display (e.g. $ty-t_1$),

T bright is the bright time (e.g. $t_3-t_2$),

N channel is the content of the particular channel that is displayed, and

k is the proportion of the total vertical sweep used
for full vertical scale.

In accordance with the present invention, when
a certain threshold value is exceeded by any channel of the
display, the maximum full scale Nmax, is constantly varied
to follow the level or contents of the highest level channel. In this situation, logic memory. Further, the attribute
memory bank can be such as to provide reserve bits to which
other attributes can be assigned, thus permitting the assignment of such attributes being done by software changes
instead of hardware changes. In prior art mode of analysing
commonly referred to as the fixed vertical scaling mode,
the vertical amplitude of the signals is established at some
predetermined level and the data are collected and fed into
the display apparatus, it sometimes occurring that certain
respective peaks of various components of the spectrum exceed this pre-established level and are not registered in
the visual display.

More specifically, if the upper limit of the
vertical scale is set at a given value A, and analytical
x-ray fluorescence of a sample is carried out in a fashion
familiar to the art, as the analysis is continued, information is continuously fed into the display device (e.g. a
television display) as a result of which, at a certain time,
the measure of the intensity of a constituent material of
the sample is at a level C and at a subsequent time, such
intensity is at a level B, with the intensity level thereafter reaching, and subsequently exceeding, level A. Consequently, the peak portion of a first sample component
(which can be the intensity of, e.g. iron in the sample) ends
up off the display while a second sample component (which
can represent the intensity of e.g. nickel in the sample)
remains fully within the display viewing field, this obviously being an undesirable result due to the inability
to gauge the peak of the first sample component.

According to the present invention the upper
limit of the range of the vertical scale is initially set at pre-set fixed value and when this value is reached by the highest data point, the upper limit of the vertical scale range is then continuously maintained at a level that is at least equal to and preferably exceeds somewhat, the highest peak value of the data, such that there is a dynamic adjustment of the upper limit of the vertical scale, thereby ensuring that all of the data are displayed and permitting the relatively low values on the vertical range to be maintained for a period of time and thus enabling reading and comparison of these lower values for a larger projection of the examination time than is available with the previously described prior art techniques. Specifically, as the intensity, i.e. the vertical scale reading of the highest peak of the data displayed (i.e. the peak for display component corresponding to the first sample component increases during the examination of the sample, the extent of the vertical range increases commensurately. As mentioned above, the visual display can be achieved with a television display, using either a vertical television raster in which historgram lines are provided by the television scan line, i.e. the display comprises one or more vertical bars or lines or a horizontal television raster.

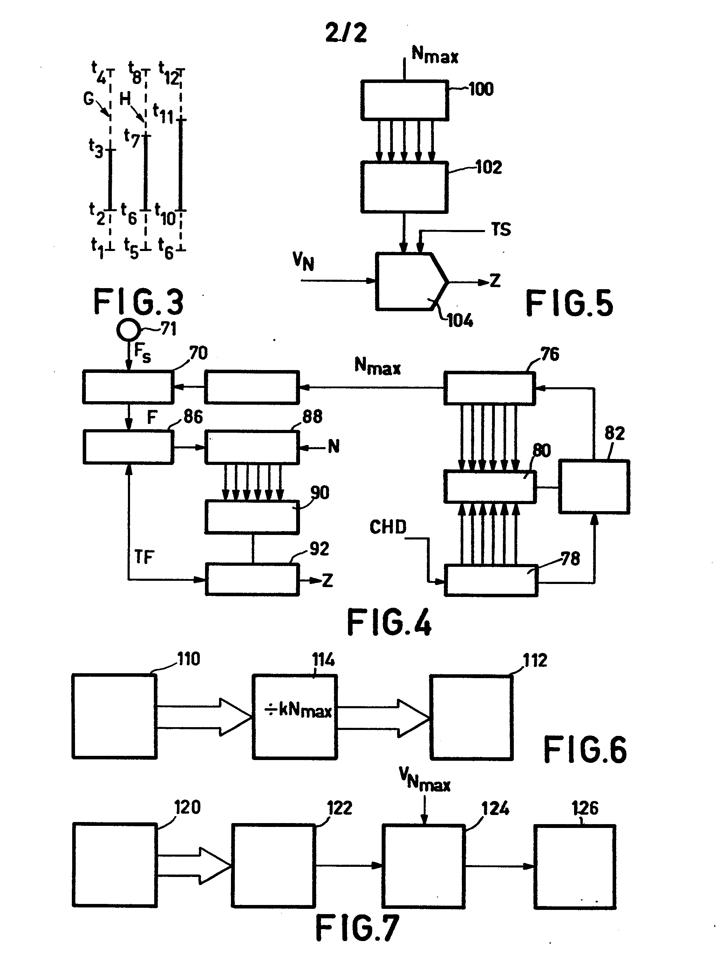

In fig. 3, where the display is produced by a vertical television raster, two successive lines G and H are shown with $t_1$ designating the beginning of the scan for line G, $t_2$ designating the starting time of the histogram being produced, $t_3$ designating the stopping time of the histogram, and $t_4$ the start of the flyback. At $t_6$ the histogram H is begun to be written with such writing stopping at $t_7$ and $t_8$ designating the start of the flyback. The starting times of the histogram, $t_2$, $t_6$, $t_{10}$ are always the same and the respective finishing times of the histograms $t_3$, $t_7$, $t_{11}$ being determined by the contents of the components or channels being displayed at those particular times.

Referring to figure 4, there is described digital means for modulating the vertical television raster according to the present invention, where the upper range limit of the display is continuously.

The output of a first attribute memory 60 of the bank 58 is fed into the display circuitry 66 (it being possible to feed into the display circuitry 66 the output of more than one attribute memory bank). The output of the first attribute memory 60 can provide one or more indices to the display circuitry, such as, for example, the brightness of a portion of interest of the display, energy range markers, peak centroid identifiers, or Z-axis modulation bits for window annunciation. Where other attribute memories address the display circuitry 66, other indices can be provided by them to the display device, such indices appearing on the display screen and being usable for reference purposes or for other purposes.

The output of a second attribute memory 62 is fed into the output circuitry 68 which can drive a scanning electron microscope (S.E.M.) display 69 to enhance an image of the inspected sample. This is a single-channel analysis, in principle.

By employing the present apparatus, the attributes or indices, that are desired for the output and display devices can be provided to them by simultaneous operation with the provision thereto of the information from the multi-channel memory instead of the prior art technique of employing separate processing steps for providing the attributes or indices to the output and display devices. The present invention provides a simpler and less expensive apparatus by virtue of the possibility of omitting the comparator (16, 18 of Fig. 1) and the necessary there still applies the equation

$$f = \frac{Nmax}{T\ histogram}$$

and, since T histogram is a constant, the frequency f is directly proportional to Nmax.

In the operation of the digital means as shown in fig. 4 for vertical television raster, the value Nmax of the highest level information channel is fed into a programmable frequency ratioing device 72 via a truncator 74, which frequency ratioing device can be a digital differential analyzer, binary rate multiplier, or any other digital device available in the art. Device 72 ensures to produce a frequency proportional to Nmax and inversely proportional to T histogram. While it is preferred that the value of N be truncated to reduce high frequency problems, this is not essential.

The threshold value for the count (vertical axis) is preset into a data register 76. In the case of spectrum collection (i.e. dynamic data collection), each time an event occurs in any channel (horizontal axis) the count magnitude is fed into a further data register 78, this data then being compared with the threshold value stored in the past data register 76 by means of a digital comparator 80. A logic circuitry element 82 then will cause the contents of data register 78 to be shifted into the first data register 76, when the data value in the further data register 78 exceeds the value of the first data register 76. Thus when the threshold value is exceeded, the last data value stored in the first data register 76 is the Nmax value. Generally, the value of $N_{max}$ at the end of the last television frame is fed into frequency ratioer 72 via truncator 74 and this value will be used to scale the following television frame. In the case of a spectrum which had been previously collected and stored, $N_{max}$ is generated using the circuitry as shown in fig. 4, but then the channel data values are compared only once, that being when the memory is loaded from the storage.

A system clock frequency, $F_s$ is also fed into the frequency ratioer 72. The output frequency f, from the frequency ratioer is then proportional to Nmax, such output frequency being fed into a gate 86, to which a television synchronizing signal is fed. The output of gate 86 is used to count down the contents of counter 88, into which the vertical scale value, Nchannel has been preset. The contents of counter are fed into detect zero means 90, whose output is fed into another gate 92. The television synchronizing signal is also fed into gate 92, the output of which provides Z modulation.

In the operation of the apparatus, the counter 88 is preset with a Nchannel value at time $t_1$, $t_5$, $t_9$, etc. (Figure 4) or at least some time between $t_3$ and $t_6$, $t_7$ and $t_{10}$ etc. Then, at time $t_2$, $t_6$, $t_{10}$ gate 86 is opened by the television synchronizing pulse, causing the frequency f (figure 4), to start counting down counter 88. Simultaneously, the television synchronizing pulse opens gate 92, allowing the output of the zero detection means to provide a Z modulation. When counter 88 is at zero value, this occurring at $t_3$, $t_7$, $t_{11}$, etc., then Z modulation will then automatically disappear since this is produced only when the zero detection means output does not represent zero. Thus, in building each TV frame, frequency ratioer 72 is loaded once per frame at the beginning of the frame and counter 88 is preset once per line.

To achieve vertical television raster modulation in the analog mode, according to the present invention (Figure 5), the value Nmax is truncated by truncator 100 (where truncation is desired, same being preferred but not required) and is converted by digital-to-analog converter 102 into a D.C. voltage which is used as an initial condition in an analog integration circuit 104 whose input is a voltage corrresponding to Nchannel, a television synchronizing signal being fed into the analog integration circuit 104. The output of the integrator 104 is logically clamped to produce a Z modulation signal.

The integrator run down is started at $t_2$, $t_6$, $t_{10}$ etc., by the television synchronizing pulse and reaches zero level at $t_3$, $t_7$, $t_{11}$, etc. This circuit is the analog equivalent of the circuit in figure 4.

To achieve horizontal television raster according to the present invention, where this is desired to be achieved by digital means, information is transferred from a multi-channel analyzer memory 110 (figure 6) to a display memory 112, the contents of each channel being divided by $kN_{max}$ by digital means 114, thus normalizing the value of each channel to a maximum vertical scale value of $N_{max}$.

Such digital means can comprise a computer, microprocessor or hardwire digital arithmetic circuitry.

Such horizontal television raster can be achieved by analog means according to a further embodiment of this invention, with a multi-channel analyzer 120 (figure 7), from which information is transferred to a digital-to-analog converter 122, from which converter information is fed into a voltage divider 124 to which $V_{N_{max}}$ is fed, the output of which voltage divider is then transferred to the analog shift register array 126 with the output therefrom being fed to a display device.

16-3-1979                    1                    PHA 20 798

CLAIMS:

1.        A multi-channel analyzer apparatus characterized in that it contains
          a) an analog-to-digital converter 56 for receiving incoming signals,
          b) a multi-channel memory 64 connected to the converter,
          c) an attribute memory bank 58 comprising at least one attribute memory and being connected to the multi-channel memory,
          d) a display circuitry 66 connected to the attribute memory bank and to said multi-channel memory,
          e) a display device connected to the display circuitry,
          f) an output circuitry 68 connected to the output memory bank, and
          g) an output device 69 for receiving and demonstrating the signals from the output circuitry.
2.        A multi-channel analyzer apparatus characterized in that a display circuitry thereof comprises
          a) means for producing a maximum signal value (Nmax) to be fit to a signal truncator 74,
          b) a frequency ratioer 70 connected to the truncator and to a system frequency clock,
          c) a first gate 86 connected to the frequency ratioer for receiving a display synchronizing signal F,

d) a counter 88 connected to the first gate, said counter receiving signals (Nchannel) to be monitored,

e) a zero detector 90 connected to the counter, and

f) a second gate 92 connected to the zero detector and to the first gate for receiving a television synchronizing signal TF from the first gate, the second gate providing an output signal Z modulating the display device.

0005289

1/2

FIG.1

FIG.2

1-Ⅱ-PHA 20798$^{C}$

FIG.3

FIG.5

FIG.4

FIG.6

FIG.7

2-II-PHA 20798^C

European Patent
Office

**EUROPEAN SEARCH REPORT**

Application number

EP 79 20 0185

| | DOCUMENTS CONSIDERED TO BE RELEVANT | | CLASSIFICATION OF THE APPLICATION (Int. Cl.²) |
|---|---|---|---|
| Category | Citation of document with indication, where appropriate, of relevant passages | Relevant to claim | |
| | US − A − 3 812 288 (CH.J.WALSH et al.)<br>* column 5, line 51 to column 6, line 8; figure 7 * | 1 | H 01 J 37/28<br>G 01 R 13/34 |
| | US − A − 4 053 831 (M. FURUKAWA et al.)<br>* abstract * | 2 | |
| | US − A − 3 765 009 (W.P.GRAVES)<br>* abstract; figure 5 * | 2 | |

TECHNICAL FIELDS
SEARCHED (Int.Cl.²)

G 01 T 1/36
G 011 V 23/22
H 01 J 37/28
/00
G 01 R 13/34
G 01 R 19/16
G 06 F 3/14
13/00

CATEGORY OF
CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 24−07−1979 | BIGGIO |

EPO Form 1503.1 06.78